# EUROPEAN PATENT APPLICATION

(11) **EP 4 534 336 A1**
(43) Date of publication of application: **09.04.2025**
(21) Application number: 23818992.2
(22) Date of filing: 31.05.2023
(51) Int. Cl.: B60L 53/80

(54) **BATTERY COMPARTMENT AND BATTERY SWAPPING STATION**

(30) Priority: 06.06.2022 CN 202221386761 U
(71) Applicant: Contemporary Amperex Technology (Hong Kong) Limited, Central, Hong Kong (HK)
(72) Inventor: CHEN, Weifeng, Ningde, Fujian 352100 (CN); CHEN, Dewei, Ningde, Fujian 352100 (CN); QUE, Shibiao, Ningde, Fujian 352100 (CN); CHEN, Disong, Ningde, Fujian 352100 (CN)
(74) Representative: Laufhütte, Dieter
(86) International application number: PCT/CN2023/097452
(87) International publication number: WO 2023/236827

(57) **Abstract**

This application provides a battery compartment and a battery swapping station. The battery compartment includes a charging device and a control device. The charging device is configured to charge a battery. The control device is connected to the charging device, and the control device is configured to control the charging device to charge the battery.

## Description

### CROSS-REFERENCE TO RELATED APPLICATIONS

This application claims priority to Chinese patent application No. 202221386761.1, filed on June 06, 2022 and entitled "BATTERY COMPARTMENT AND BATTERY SWAPPING STATION", which is incorporated herein by reference in its entirety.

### TECHNICAL FIELD

This application relates to the field of battery technologies, and specifically relates to a battery compartment and a battery swapping station.

### BACKGROUND

With the increasing attention to environmental protection, electric apparatuses such as electric transportation tools have been rapidly popularized, where batteries in the electric apparatuses enable the electric apparatuses to have a suitable endurance mileage.

However, in the related art, the effect of controlling charging of batteries in electric apparatuses is not satisfactory.

### SUMMARY

This application provides a battery compartment and a battery swapping station, which can facilitate charging control of batteries.

According to a first aspect, an embodiment of this application provides a battery compartment, including: a charging device and a control device. The charging device is configured to charge a battery. The control device is connected to the charging device, and the control device is configured to control the charging device to charge the battery.

In this embodiment, the control device is connected to the charging device, so that in the battery compartment, at least one of various charging statuses such as power and duration of charging of the battery by the charging device is autonomously controlled. Alternatively, the control device can be configured to control whether to charge the battery, can control power to be off when the battery is abnormal so as to conveniently control various statuses of the battery, thereby improving the safety and reliability of the battery compartment and realizing diversified power of the battery in the battery compartment.

In some embodiments of this application, the charging device includes a charging seat and a charging cabinet, the charging seat is configured to accommodate the battery, and the charging cabinet is connected to the charging seat to charge the battery through the charging seat.

In these embodiments, the charging device includes the charging seat and the charging cabinet, and the charging cabinet can charge the battery in the charging seat, further simplifying the charging of the battery.

In some embodiments of this application, the battery compartment further includes a first cable, where the first cable is connected between the charging cabinet and the charging seat.

In these embodiments, the control device can control the charging cabinet to transfer electrical energy to the charging seat through the first cable, so as to charge the battery.

In some embodiments of this application, the control device includes a control module and a monitoring module connected to the control module. The control module is connected to the charging cabinet to control the charging cabinet. The monitoring module is configured to be connected to the battery through the charging seat, so as to monitor a status of the battery.

In these embodiments, the control module can not only control the charging cabinet to charge the battery, but also control the monitoring module to monitor the status of the battery, so as to better understand the charging status of the battery.

In some embodiments of this application, the battery compartment further includes a second cable, where the second cable is connected between the control module and the charging cabinet.

In these embodiments, the control module can transmit an instruction to the charging cabinet through the second cable, so as to facilitate the charging of the battery in the charging seat

In some embodiments of this application, the charging seat includes a connector configured to be electrically connected to the battery, and the second cable is also connected between the monitoring module and the connector.

In these embodiments, the connector of the charging seat is configured to be electrically connect to the battery, so as to cooperate with the charging seat to charge the battery. In addition, the monitoring module is connected to the connector through the second cable, such that the monitoring module can accurately monitor the status of the battery.

In some embodiments of this application, the battery compartment includes a first wiring pipe, where the first wiring pipe is configured to accommodate at least part of the first cable and the second cable.

In these embodiments, the first wiring pipe can protect the first cable and the second cable. In addition, the first wiring pipe can also gather the first cable and the second cable, realizing simpler and tidier cable arrangement.

In some embodiments of this application, the battery compartment further includes an insulating partition part, where the insulating partition part is disposed in the first wiring pipe and is configured to divide the first wiring pipe into a first portion and a second portion, at least part of the first cable is accommodated in the first portion, and at least part of the second cable is accommodated in the second portion.

In these embodiments, the insulating partition part divides the first wiring pipe into the first portion and the second portion, at least part of the first cable is accommodated in the first portion, and the second cable is accommodated in the second portion, realizing clearer cable arrangement and facilitating maintenance of the cables.

In some embodiments of this application, the battery compartment includes a first compartment body and a second compartment body stacked in a vertical direction, and the first compartment body is located below the second compartment body. The charging cabinet is disposed in the first compartment body, at least part of the charging seat is disposed in the first compartment body, and a remaining part of the charging seat is disposed in the second compartment body.

In these embodiments, by the provision of the first compartment body and the second compartment body, components of the battery compartment are separated, realizing reasonable arrangement and reducing mutual interference between the components.

In some embodiments of this application, the first compartment body includes a control chamber and a charging chamber, where the control device is disposed in the control chamber, the charging seat and the charging cabinet are at least partially disposed in the charging chamber, and the first wiring pipe extends from the charging chamber towards the control chamber.

In these embodiments, the first compartment body includes a control chamber and a charging chamber, realizing more reasonable arrangement of the first compartment body.

In some embodiments of this application, the battery compartment further includes a first isolating member disposed between the first compartment body and the second compartment body.

In these embodiments, the first isolating member separates the first compartment body from the second compartment body, reducing mutual interference between the components in the first compartment body and the components in the second compartment body.

In some embodiments of this application, the first isolating member is provided with a wiring through hole, and the wiring through hole is for the first cable to pass through the first isolating member.

In these embodiments, the provision of the wiring through hole on the first isolating member provides convenience for the control module to connect the components in the second compartment body through the first cable.

In some embodiments of this application, the battery compartment further includes a thermal management device and a heat exchange pipe. The thermal management device is disposed in the first compartment body, and the thermal management device is configured to perform thermal management on the charged battery. The heat exchange pipe is connected between the thermal management device and the charging seat.

In these embodiments, the provision of the thermal management component and the heat exchange pipe can achieve thermal management of the battery, so as to improve the charging safety of the battery.

In some embodiments of this application, the battery compartment further includes a water blocking part protruding out with respect to a surface of the first isolating member facing away from the first compartment body, where the water blocking part includes a through cavity; the water blocking part is disposed around the wiring through hole to allow the first cable and the heat exchange pipe to pass through the through cavity and the wiring through hole that are in communication with each other.

In these embodiments, the provision of the water blocking part can prevent contact between water in the second compartment body and the first cable so as not to cause safety issues.

In some embodiments of this application, the water blocking part includes a water blocking part body and a second isolating member. The water blocking part body includes the through cavity. The second isolating member is disposed in the through cavity and is configured to isolate the first cable from the heat exchange pipe.

In these embodiments, the second isolating member is disposed in the through cavity of the water blocking part body to isolate the first cable from the heat exchange pipe, so as to reduce mutual interference between the first cable and the heat exchange pipe.

In some embodiments of this application, the battery compartment further includes a second wiring pipe. The monitoring module includes a proximity sensor and a third cable, and the third cable is disposed in the second wiring pipe and connected between the proximity sensor and the control module.

In these embodiments, the proximity sensor can sense whether the battery is in the charging seat, and transmit a sensing signal to the control module through the third cable, such that the control module can control the charging cabinet to charge the battery in the charging seat according to the sensing signal.

According to a second aspect, this application provides a battery swapping station including the battery compartment according to any one of the foregoing embodiments.

In the foregoing embodiments, since the battery swapping station includes the battery compartment according to the foregoing embodiments, the battery swapping station can facilitate charging control of the battery.

The foregoing description is merely an overview of the technical solution of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

Persons of ordinary skill in the art will be clear about various other advantages and benefits by reading the detailed description of the preferred embodiments below. The accompanying drawings are merely intended to illustrate the preferred embodiments and are not intended to limit this application. In addition, in all the accompanying drawings, the same reference signs represent the same components. In the accompanying drawings:
FIG. 1 is a schematic structural diagram of a battery swapping station according to some embodiments of this application;
FIG. 2 is a schematic structural top view of a battery compartment according to some embodiments of this application;
FIG. 3 is a schematic structural diagram of a first compartment body in a battery compartment according to some embodiments of this application;
FIG. 4 is a schematic structural diagram of a second compartment body in a battery compartment according to some embodiments of this application;
FIG. 5 is a schematic structural cross-sectional view of a first wiring pipe in a battery compartment according to some embodiments of this application; and
FIG. 6 is a locally enlarged view of position S in FIG. 4.

Reference signs in specific embodiments are as follows:
100. battery swapping station;
10. battery compartment;
11. charging device; 111. charging cabinet; 112. charging seat;
12. control device; 121. control module;
13. first wiring pipe; 131. insulating partition part; 132. first portion; 133. second portion;
14. second wiring pipe;
15. first compartment body; 151. control chamber; 152. charging chamber;
16. second compartment body;
17. first isolating member; 171. wiring through hole;
18. water blocking part; 181. water blocking part body; 182. second isolating member;
19. thermal management device; and 191. heat exchange pipe.

### DESCRIPTION OF EMBODIMENTS

The following describes in detail the embodiments of technical solutions of this application with reference to the accompanying drawings. The following embodiments are merely intended for a clearer description of the technical solutions of this application and therefore are merely used as examples which do not constitute any limitation on the protection scope of this application.

Unless otherwise defined, all technical and scientific terms used herein shall have the same meanings as commonly understood by persons skilled in the art to which this application pertains. The terms used herein are intended to merely describe the specific embodiments rather than to limit this application. The terms "include", "comprise", and any other variations thereof in the specification, claims and brief description of drawings of this application are intended to cover non-exclusive inclusions.

In the descriptions of the embodiments of this application, the technical terms "first", "second", and the like are merely intended to distinguish between different objects, and shall not be understood as any indication or implication of relative importance or any implicit indication of the number, specific sequence, or primary-secondary relationship of the technical features indicated. In the descriptions of the embodiments of this application, "a plurality of" means more than two, unless otherwise specifically defined.

In this specification, reference to "embodiment" means that specific features, structures or characteristics described with reference to the embodiment may be incorporated in at least one embodiment of this application. The word "embodiment" appearing in various places in this specification does not necessarily refer to the same embodiment or an independent or alternative embodiment that is exclusive of other embodiments. Persons skilled in the art explicitly and implicitly understand that the embodiments described herein may be combined with other embodiments.

In the descriptions of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the descriptions of the embodiments of this application, the term "a plurality of" means more than two (inclusive). Similarly, "a plurality of groups" means more than two (inclusive) groups, and "a plurality of pieces" means more than two (inclusive) pieces.

In the description of the embodiments of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for ease and brevity of the descriptions of the embodiments of this application rather than indicating or implying that the means or components mentioned must have specific orientations or must be constructed or manipulated according to specific orientations, and therefore shall not be construed as any limitation on the embodiments of this application.

In the descriptions of the embodiments of this application, unless otherwise specified and defined explicitly, the technical terms "mounting", "connection", "join", and "fastening" should be understood in their general senses. For example, they may refer to a fixed connection, a detachable connection, or an integral connection, may refer to a mechanical connection or an electrical connection, and may refer to a direct connection, an indirect connection via an intermediate medium, an internal communication between two elements, or an interaction between two elements. Persons of ordinary skill in the art can understand specific meanings of these terms in the embodiments of this application as appropriate to specific situations.

The battery disclosed in this application may be used without limitation in electric apparatuses such as vehicles, ships, and aircrafts. A battery cell, the battery, and the like disclosed in this application may be used to constitute a power supply system of the electric apparatus. This helps to improve the safety performance of the electric apparatus in use.

In this application, the electric apparatus may be but is not limited to a mobile phone, a tablet computer, a laptop computer, an electric toy, an electric tool, an electric bicycle, an electric vehicle, a ship, and a spacecraft. The electric toy may include a fixed or mobile electric toy, for example, a game console, an electric toy car, an electric toy ship, and an electric toy airplane. The spacecraft may include an airplane, a rocket, a space shuttle, a spaceship, and the like.

For ease of description, an electric apparatus of an embodiment of this application being an electric vehicle is used as an example for description of the following embodiments.

The electric vehicle may be a fossil fuel vehicle, a natural-gas vehicle, or a new energy vehicle. The new energy vehicle may be a battery electric vehicle, a hybrid electric vehicle, a range-extended electric vehicle, or the like. The electric vehicle is provided with a battery inside, where the battery may be arranged at the bottom, front, or rear of the vehicle. The battery may be configured to supply power to the electric vehicle. For example, the battery may be used as an operational power source for the electric vehicle. The electric vehicle may further include a controller and a motor, where the controller is configured to control the battery to supply power to the motor, for example, to satisfy power needs of start, navigation, and driving of the vehicle.

In some embodiments of this application, the battery can be used as not only the operational power source for the electric vehicle but also a driving power source for the electric vehicle, replacing all or part of the fossil fuel or the natural gas to provide driving power for the electric vehicle.

In this application, the battery is a single physical module that includes one or more battery cells for providing a higher voltage and capacity. For example, the battery mentioned in this application may include a battery module, a battery pack, or the like. A battery typically further includes a box for packaging one or more battery cells. The box can prevent liquids or other foreign matter from affecting charging or discharging of the battery cell.

In some embodiments of this application, the battery includes a box and a battery cell, where the battery cell is accommodated in the box.

The box is configured to provide an accommodating space for the battery cell, and the box may be a variety of structures. In some embodiments, the box may include a first box body and a second box body. The first box body and the second box body are engaged with each other to jointly define an accommodating space for accommodating the battery cells. The second box body may be a hollow structure with one end open, the first box body may be a plate structure, and the first box body covers an open side of the second box body, so that the first box body and the second box body jointly define the accommodating space. The first box body and the second box body may both be a hollow structure with one side open, and the open side of the first box body covers the open side of the second box body. Certainly, the box formed by the first box body and the second box body may be of various shapes, for example, a cylinder or a cuboid.

In the battery, a plurality of battery cells may be provided, and the plurality of battery cells may be connected in series, parallel, or series-parallel, where being connected in series-parallel means a combination of series connection and parallel connections of the plurality of battery cells. The plurality of battery cells may be directly connected in series, parallel, or series-parallel, and then an entirety of the plurality of battery cells is accommodated in the box. Certainly, the battery may alternatively be formed in a manner that the plurality of battery cells are connected in series, parallel, or series-parallel first to form battery modules and then a plurality of battery modules are connected in series, parallel, or series-parallel to form an entirety which is accommodated in the box.

Each battery cell may be a secondary battery or a primary battery, or may be a lithium-sulfur battery, a sodium-ion battery, or a magnesium-ion battery, without being limited thereto. The battery cell may be cylindrical, flat, cuboid, or of other shapes.

The battery cell is a smallest unit constituting the battery and includes an end cover, a housing, an electrode assembly, and other functional components.

The end cover refers to a component that covers an opening of the housing to insulate internal environment of the battery cell from external environment. Without limitation, a shape of the end cover may fit with that of the housing, so that the end cover can match the housing. Optionally, the end cover may be made of a material with given hardness and strength (for example, aluminum alloy), so that the end cover is less likely to deform when subjected to extrusion and collision, enabling the battery cell to have higher structural strength and enhanced safety performance. The end cover may be provided with functional components such as an electrode terminal. The electrode terminal may be configured to be electrically connected to the electrode assembly for outputting or inputting electrical energy of the battery cell.

In some embodiments, the end cover may also be provided with a pressure relief mechanism configured to relieve internal pressure when the internal pressure or temperature in the battery cell reaches a threshold. The end cover may also be made of various materials, for example, copper, iron, aluminum, stainless steel, aluminum alloy, and plastic. This is not particularly limited in the embodiments of this application.

In some embodiments, an insulating member may also be disposed at an inner side of the end cover. The insulating member may be configured to isolate electrical connection components in the housing from the end cover, thereby reducing the risk of short circuit. For example, the insulating member may be made of plastic, rubber, or the like.

The housing is an assembly configured to form an internal environment of the battery cell together with the end cover, where the formed internal environment may be used for accommodating the electrode assembly, an electrolyte solution, and other components. The housing and the end cover may be independent components, and an opening may be provided in the housing, such that the end cover covers the opening to form the internal environment of the battery cell. Without limitation, the end cover and the housing may alternatively be integrated. Specifically, the end cover and the housing may form a shared connection surface before other components are disposed inside the housing, and then the end cover covers the housing when the inside of the housing needs to be enclosed. The housing may be of various shapes and sizes, such as a cuboid, a cylinder, and a hexagonal prism. Specifically, the shape of the housing may be determined based on a specific shape and size of the electrode assembly. The housing may be made of various materials, for example, copper, iron, aluminum, stainless steel, aluminum alloy, and plastic. This is not particularly limited in the embodiments of this application.

The electrode assembly is a component in which electrochemical reactions take place in the battery cell. The housing may include one or more electrode assemblies. The electrode assembly is mainly formed by winding or stacking a positive electrode plate and a negative electrode plate, and a separator is typically disposed between the positive electrode plate and the negative electrode plate. Portions of the positive electrode plate and the negative electrode plate with active substances constitute a body portion of the electrode assembly, while portions of the positive electrode plate and the negative electrode plate without active substances each constitute a tab. A positive tab and a negative tab may both be located at one end of the body portion or be located at two ends of the body portion respectively. During charging and discharging of the battery, a positive electrode active substance and a negative electrode active substance react with the electrolyte solution, and the tabs are connected to electrode terminals to form a current loop.

Battery swapping technology refers to a technology of directly replacing a battery of an electric apparatus to update available power of the electric apparatus. Differing from a traditional charging technology, the battery swapping technology enables the electric apparatus to be fully charged or to achieve more power within a shorter time, thereby effectively improving the convenience of electric apparatuses such as electric transportation tools, and facilitating wider application of the electric apparatuses such as electric transportation tools.

A battery swapping station refers to a system that specifically implements a battery replacement process, and a battery swapping station typically includes a charging device and a battery swapping device, and is provided with a certain number of batteries for replacement. The charging device is configured to charge a battery that is not fully charged, and the battery swapping device is configured to dismount a battery on the electric apparatus and replace this battery with a fully charged battery on the electric apparatus. The battery swapping device herein may be electric transportation tools such as electric vehicles, electric ships, and electronic aircraft. By arrangement of battery swapping stations in transit areas of the foregoing transportation tools, batteries of these electric transportation tools can be replaced before their power is exhausted. The following introduces a battery compartment used in a battery swapping station of this application by using an electric vehicle as an example.

With the increasing attention to environmental protection, electric vehicles have been rapidly popularized, and battery swapping stations can efficiently replace batteries for electric vehicles, to enable the electric vehicles to restore to a fully charged state or a high-power state within a short time, thereby effectively solving the problem of poor endurance of electric vehicles during travel in the prior art. However, in the related art, while a charging device in a battery swapping station is charging a battery, the charging device typically relies on a full-charge protection mechanism of the battery, resulting in poor safety and failing to autonomously control a target power of charging of the battery, thus making it difficult to meet needs of customers for diversified power of a replacing battery.

In view of this, an embodiment of this application provides a battery compartment and a battery swapping station, which can facilitate charging of batteries.

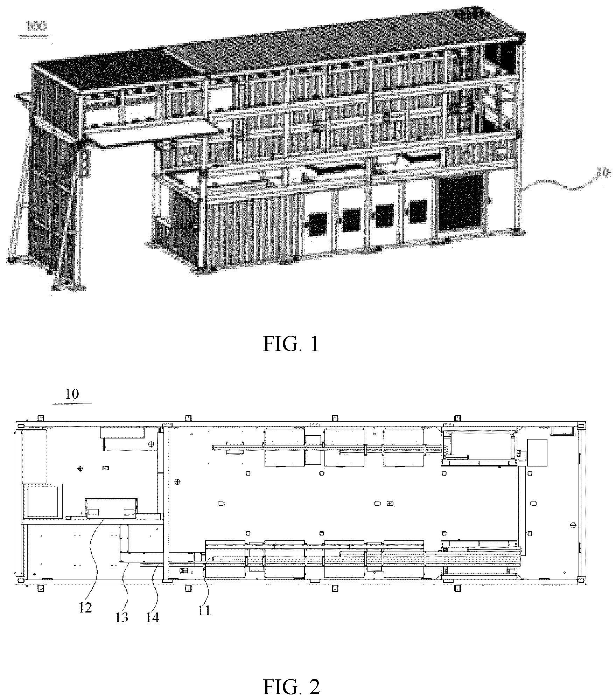

FIG. 1 is a schematic structural diagram of a battery swapping station according to some embodiments of this application.

As shown in FIG. 1, the battery swapping station 100 includes a battery compartment 10. The battery compartment 10 is configured to charge a battery of an electric vehicle, thereby implementing charging control for the battery.

FIG. 2 is a schematic structural top view of a battery compartment according to some embodiments of this application.

Referring to FIG. 2, an embodiment of this application provides a battery compartment 10, including a charging device 11 and a control device 12. The charging device 11 is configured to charge a battery. The control device 12 is connected to the charging device 11, and the control device 12 is configured to control the charging device 11 to charge the battery.

The charging device 11 may be a direct-current charging device 11, an alternating-current charging device 11, or a direct-current and alternating-current integrated charging device 11. This is not specifically limited in the embodiments of this application. The charging device 11 can convert electrical energy of a mains supply into electrical energy for a vehicle-mounted battery of an electric vehicle. In addition, one or more charging devices 11 may be provided. This is not specifically limited in the embodiments of this application.

The control device 12 may be electrically connected or communicatively connected to the charging device 11, so as to control the charging device 11 to charge the battery. Corresponding to the charging device 11, one or more control devices 12 may be provided. This is not specifically limited in the embodiments of this application.

In the foregoing embodiments, the control device 12 is connected to the charging device 11, such that in the battery compartment 10, at least one of various charging statuses such as power, duration, and time of charging of the battery by the charging device 11 is autonomously controlled. Alternatively, the control device 12 can be configured to control whether to charge the battery, can control power to be off when the battery is abnormal so as to conveniently control various statuses of the battery, thereby improving the safety and reliability of the battery compartment and realizing diversified power of the battery in the battery compartment.

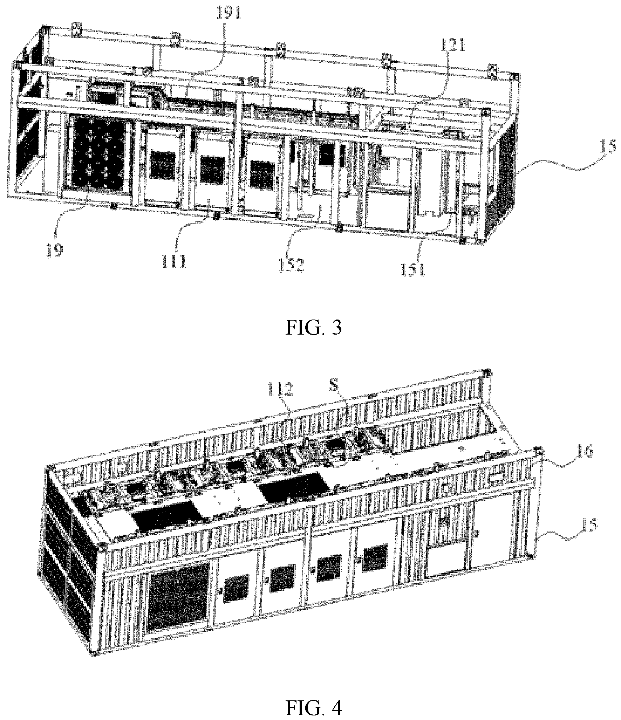

FIG. 3 is a schematic structural diagram of a first compartment body in a battery compartment according to some embodiments of this application. FIG. 4 is a schematic structural diagram of a second compartment body in a battery compartment according to some embodiments of this application.

Referring to FIG. 2 and FIG. 3, in some embodiments of this application, the charging device 11 includes a charging seat 112 and a charging cabinet 111, where the charging seat 112 is configured to accommodate the battery, and the charging cabinet 111 is connected to the charging seat 112 to charge the battery through the charging seat 112.

The charging cabinet 111 may be connected to a mains supply to charge the battery in the charging seat 112. The charging cabinet 111 may be square, round, or of other shapes. This is not specifically limited in the embodiments of this application. In addition, the charging cabinet 111 supports fast charging, allowing the charging cabinet 111 and the charging seat 112 to output both large current and large voltage, thereby meeting the requirements of large current and large voltage of the battery compartment 10, and reducing installation costs in comparison with a case in which a power supply line connected to the mains supply is provided.

The charging seat 112 may be designed according to a model of the battery, so as to meet the charging requirements of batteries of different models.

In these embodiments, the charging cabinet 111 can charge the battery in the charging seat 112, further simplifying the charging of the battery.

In some embodiments of this application, a plurality of charging cabinets 111 and charging seats 112 are provided, and the plurality of charging cabinets 111 can charge batteries in the plurality of charging seats 112. In this way, a plurality of batteries can be charged, thereby improving the charging efficiency, shortening the charging time, and improving the user experience.

In addition, the plurality of charging cabinets 111 can communicate with each other through a communication bus, and the communication bus is connected to the control device 12, thereby realizing data interaction. A communication method is not specifically limited in the embodiments of this application, as long as the charging cabinets 111 can be communicatively connected with each other. For example, the communication between the charging cabinets 111 can be realized by broadband power line carrier (HPLC), CAN bus, Ethernet, Zigbee, Bluetooth, or other methods.

In some embodiments of this application, the plurality of charging cabinets 111 and the plurality of charging seats 112 are arranged in one-to-one correspondence, facilitating the charging of the batteries.

In some embodiments of this application, the battery compartment 10 further includes a first cable, where the first cable is connected between the charging cabinet 111 and the charging seat 112.

In these embodiments, the control device 12 can control the charging cabinet 111 to transfer electrical energy to the charging seat 112 through the first cable, so as to charge the battery. In addition, the first cable is arranged in the battery compartment 10, so as to be prevented from being exposed outside the battery compartment 10, thereby reducing the aging rate of the first cable and prolonging the service life of the first cable.

In some embodiments of this application, the control device 12 includes a control module 121 and a monitoring module connected to the control module 121, where the control module 121 is connected to the charging cabinet 111 to control the charging cabinet 111, and the monitoring module is configured to be connected to the battery through the charging seat 112, so as to monitor the status of the battery.

The control module 121 may be disposed at any position in the battery compartment 10. This is not specifically limited in this application. Each control module 121 may be an apparatus capable of implementing control functions, such as a single-chip and a programmable logic controller.

The monitoring module may alternatively be disposed at any position of the charging seat 112. This is not specifically limited in this application. The monitoring module may serve as an acquisition module, and the acquisition module acquires a status of the battery, for example, current, voltage, and temperature.

In these embodiments, the control module 121 can not only control the charging cabinet 111 to charge the battery, but also control the monitoring module to monitor the status of the battery, so as to better understand the charging status of the battery.

In some embodiments of this application, the battery compartment further includes a second cable, where the second cable is connected between the control module 121 and the charging cabinet 111.

In these embodiments, the control module 121 can transmit an instruction to the charging cabinet 111 through the second cable, so as to facilitate the charging of the battery in the charging seat 112. In addition, the second cable is arranged in the battery compartment 10, so as to be prevented from being exposed outside the battery compartment 10, thereby reducing the aging rate of the second cable and prolonging the service life of the second cable.

In some embodiments of this application, the charging seat 112 includes a connector configured to be electrically connected to the battery, and the second cable is also connected between the monitoring module and the connector.

In these embodiments, the connector of the charging seat 112 is configured to be electrically connected to the battery, so as to cooperate with the charging seat 112 to charge the battery. In addition, the monitoring module is connected to the connector through the second cable, such that the monitoring module can accurately monitor the status of the battery.

Referring to FIG. 1, in some embodiments of this application, the battery compartment 10 includes a first wiring pipe 13, where the first wiring pipe 13 is configured to accommodate at least part of the first cable and the second cable.

In these embodiments, the first wiring pipe 13 can protect the first cable and the second cable. In addition, the first wiring pipe 13 can also gather the first cable and the second cable, realizing simpler and tidier cable arrangement.

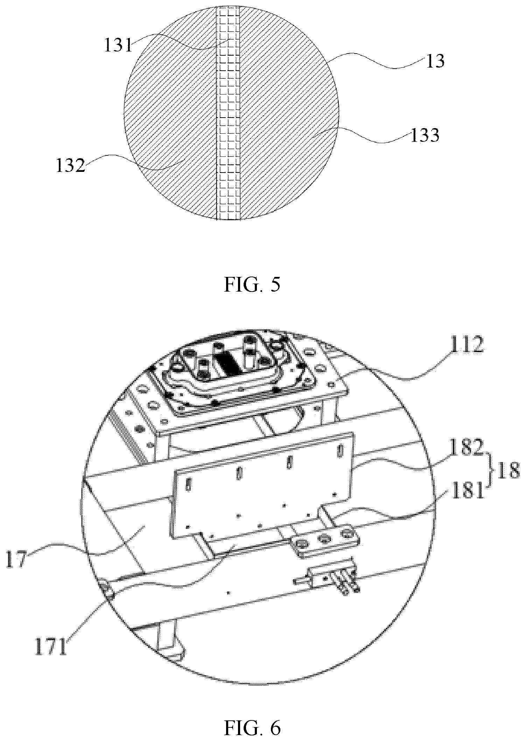

FIG. 5 is a cross-sectional view of a first wiring pipe in a battery compartment according to some embodiments of this application.

Referring to FIG. 5, in some embodiments of this application, the battery compartment further includes an insulating partition part 131, where the insulating partition part 131 is disposed in the first wiring pipe 13 and is configured to divide the first wiring pipe 13 into a first portion 132 and a second portion 133, at least part of the first cable is accommodated in the first portion 132, and at least part of the second cable is accommodated in the second portion 133.

In these embodiments, the insulating partition part 131 divides the first wiring pipe 13 into the first portion 132 and the second portion 133, at least part of the first cable is accommodated in the first portion 132, and the second cable is accommodated in the second portion 133, realizing clearer cable arrangement and facilitating maintenance of the cables.

Referring to FIG. 3, in some embodiments of this application, the battery compartment 10 includes a first compartment body 15 and a second compartment body 16 stacked in a vertical direction, where the first compartment body 15 is located below the second compartment body 16. The charging cabinet 111 is disposed in the first compartment body 15, at least part of the charging seat 112 is disposed in the first compartment body 15, and a remaining part of the charging seat 112 is disposed in the second compartment body 16.

In these embodiments, by the provision of the first compartment body 15 and the second compartment body 16, components of the battery compartment 10 are separated, realizing reasonable arrangement and reducing mutual interference between the components. In addition, a height of the first compartment body 15 and a height of the second compartment body 16 are adapted to a position of a battery in an electric vehicle, such that the battery can be conveniently moved into the charging seat 112 for charging.

In some other embodiments of this application, the battery compartment 10 may alternatively include a first compartment body 15 and a second compartment body 16 disposed in a horizontal direction, where the charging cabinet 111 is disposed in the first compartment body 15, at least part of the charging seat 112 is disposed in the first compartment body 15, and a remaining part of the charging seat 112 is disposed in the second compartment body 16.

Referring to FIG. 3, in some embodiments of this application, the first compartment body 15 includes a control chamber 151 and a charging chamber 152, where the control device 12 is disposed in the control chamber 151, the charging seat 112 and the charging cabinet 111 are at least partially disposed in the charging chamber 152, and the first wiring pipe 13 extends from the charging chamber 152 towards the control chamber 151.

In these embodiments, the first compartment body 15 is further reasonably arranged to include the control chamber 151 and the charging chamber 152, where the control module 121 and the charging device 11 are respectively and correspondingly disposed in the control chamber 151 and the charging chamber 152, reducing mutual interference between the control module 121 and the charging device 11.

FIG. 6 is a locally enlarged view of position S in FIG. 4.

Referring to FIG. 6, in some embodiments of this application, the battery compartment further includes a first isolating member 17 disposed between the first compartment body 15 and the second compartment body 16.

The first isolating member 17 may be made of an insulating material capable of insulating heat, for example, rubber.

In these embodiments, the first isolating member 17 isolates the first compartment body 15 from the second compartment body 16, making them respectively form independent spaces, so as to reduce mutual interference between the components in the first compartment body 15 and components in the second compartment body 16.

Still referring to FIG. 6, in some embodiments of this application, the first isolating member 17 is provided with a wiring through hole 171, where the wiring through hole 171 is used for the first cable to pass through the first isolating member 17.

In these embodiments, the provision of the wiring through hole 171 on the first isolating member 17 provides convenience for the control module 121 to connect the components such as the charging seat 112 and the monitoring module in the second compartment body 16 through the first cable, and realizes tidier arrangement of the first cable.

Referring to FIG. 3, in some embodiments of this application, the battery compartment further includes a thermal management device 19 and a heat exchange pipe 191. The thermal management device 19 is disposed in the first compartment body 15, where the thermal management device 19 is configured to implement thermal management on a battery that is being charged, such as a cooling treatment or a heating treatment. Specifically, a specific thermal treatment method can be determined based on the status of the battery. The heat exchange pipe 191 is connected between the thermal management device 19 and the charging seat 112.

In these embodiments, the provision of the thermal management component 19 and the heat exchange pipe 191 can realize thermal management of the battery, so as to improve the charging safety of the battery. For example, when the temperature of the battery is high, the thermal management component 19 transfers a cooling medium such as cold water through the heat exchange pipe 191 to lower a charging temperature of the battery; and when the temperature in the battery compartment 10 is low, the thermal management component 19 transfers a heating medium such as hot water through the heat exchange pipe 191 to increase the temperature in the battery compartment 10, so as to ensure that the battery can be smoothly charged.

Referring to FIG.4 and FIG.6, in some embodiments of this application, the battery compartment further includes a water blocking part 18 protruding out with respect to a surface of the first isolating member 17 facing away from the first compartment body 15, where the water blocking part 18 includes a through cavity, the water blocking part 18 is disposed around the wiring through hole 171 to allow the first cable and the heat exchange pipe 191 to pass through the through cavity and the wiring through hole 171 that are in communication with each other.

In these embodiments, the provision of the water blocking part 18 can prevent contact between water and the first cable so as not to cause safety issues.

Still referring to FIG. 6, in some embodiments of this application, the water blocking part 18 includes: a water blocking part body 181 and a second isolating member 182. The water blocking part body 181 includes the through cavity. The second isolating member 182 is disposed in the through cavity and is configured to isolate the first cable from the heat exchange pipe 191.

The water blocking part body 181 may be a tubular component for preventing external water from entering the pipe and contacting the first cable. The second isolating member 182 may be made of an insulating material capable of insulating heat, for example, rubber.

In these embodiments, the second isolating member 182 is disposed in the through cavity of the water blocking part body 181 to isolate the first cable from the heat exchange pipe 191, so as to reduce mutual interference between the first cable and the heat exchange pipe 191.

Referring to FIG. 2, in some embodiments of this application, the battery compartment 10 further includes a second wiring pipe 14. The monitoring module includes a proximity sensor and a third cable, where the third cable is disposed in the second wiring pipe 14 and is connected between the proximity sensor and the control module 121.

In these embodiments, the proximity sensor can sense whether the battery is in the charging seat 112, and transmit a sensing signal to the control module 121 through the third cable, such that the control module 121 can control the charging cabinet 111 to charge the battery in the charging seat 112 according to the sensing signal.

Referring to FIG. 1, this application provides a battery swapping station, where the battery swapping station 100 includes the battery compartment 10 according to any one of the foregoing embodiments.

In these embodiments, since the battery swapping station includes the battery compartment 10 according to the foregoing embodiments, the battery swapping station 100 can facilitate charging control of the battery.

According to some embodiments of this application, the battery compartment 10 includes a first compartment body 15 and a second compartment body 16 stacked in a vertical direction, as well as a charging device 11 and a control device 12. The first compartment body 15 is located below the second compartment body 16. The control device 12 is disposed in the first compartment body 15, at least part of the charging device 11 is disposed in the first compartment body 15, and a remaining part of the charging device 11 is disposed in the second compartment body 16. This not only realizes more reasonable arrangement of the battery compartment 10 but also facilitates charging control of the battery.

In conclusion, it should be noted that the above embodiments are merely used for describing the technical solutions of this application rather than limiting this application. Although this application is described in detail with reference to the foregoing embodiments, persons of ordinary skill in the art should understand that they may still make modifications to the technical solutions described in the foregoing embodiments or make equivalent replacements to some or all technical features thereof without departing from the scope of the technical solutions of the embodiments of this application. They should all be covered in the scope of the claims and specification of this application. In particular, as long as there is no structural conflict, the various technical features mentioned in the embodiments can be combined in any manners. This application is not limited to the specific embodiments disclosed in this specification but includes all technical solutions falling within the scope of the claims.

## Claims

1. A battery compartment, comprising:
a charging device, configured to charge a battery; and
a control device connected to the charging device, wherein the control device is configured to control the charging device to charge the battery.

2. The battery compartment according to claim 1, wherein the charging device comprises a charging seat and a charging cabinet, the charging seat is configured to accommodate the battery, and the charging cabinet is connected to the charging seat to charge the battery through the charging seat.

3. The battery compartment according to claim 2, further comprising a first cable, wherein the first cable is connected between the charging cabinet and the charging seat.

4. The battery compartment according to claim 3, wherein the control device comprises a control module and a monitoring module connected to the control module, the control module is connected to the charging cabinet to control the charging cabinet, and the monitoring module is configured to be connected to the battery through the charging seat, so as to monitor a status of the battery.

5. The battery compartment according to claim 4, further comprising a second cable, wherein the second cable is connected between the control module and the charging cabinet.

6. The battery compartment according to claim 5, wherein the charging seat comprises a connector configured to be electrically connected to the battery, and the second cable is also connected between the monitoring module and the connector.

7. The battery compartment according to claim 5 or 6, wherein the battery compartment comprises a first wiring pipe, and the first wiring pipe is configured to accommodate at least part of the first cable and the second cable.

8. The battery compartment according to claim 7, further comprising an insulating partition part, wherein the insulating partition part is disposed in the first wiring pipe and is configured to divide the first wiring pipe into a first portion and a second portion, at least part of the first cable is accommodated in the first portion, and at least part of the second cable is accommodated in the second portion.

9. The battery compartment according to claim 7 or 8, wherein the battery compartment comprises a first compartment body and a second compartment body stacked in a vertical direction; the first compartment body is located below the second compartment body; and
the charging cabinet is disposed in the first compartment body, at least part of the charging seat is disposed in the first compartment body, and a remaining part of the charging seat is disposed in the second compartment body.

10. The battery compartment according to claim 9, wherein the first compartment body comprises a control chamber and a charging chamber, the control device is disposed in the control chamber, the charging seat and the charging cabinet are at least partially disposed in the charging chamber, and the first wiring pipe extends from the charging chamber towards the control chamber.

11. The battery compartment according to claim 9 or 10, further comprising a first isolating member disposed between the first compartment body and the second compartment body.

12. The battery compartment according to claim 11, wherein the first isolating member is provided with a wiring through hole in a thickness direction, and the wiring through hole is for the first cable to pass through the first isolating member.

13. The battery compartment according to claim 12, further comprising:
a thermal management device disposed in the first compartment body, wherein the thermal management device is configured to perform thermal management on the charged battery; and
a heat exchange pipe, connected between the thermal management device and the charging seat.

14. The battery compartment according to claim 13, further comprising a water blocking part protruding out with respect to a surface of the first isolating member facing away from the first compartment body, wherein the water blocking part comprises a through cavity; the water blocking part is disposed around the wiring through hole to allow the first cable and the heat exchange pipe to pass through the through cavity and the wiring through hole that are in communication with each other.

15. The battery compartment according to claim 14, wherein the water blocking part comprises:
a water blocking part body comprising the through cavity; and
a second isolating member, disposed in the through cavity and configured to isolate the first cable from the heat exchange pipe.

16. The battery compartment according to any one of claims 4 to 15, further comprising a second wiring pipe; wherein
the monitoring module comprises a proximity sensor and a third cable, and the third cable is disposed in the second wiring pipe and connected between the proximity sensor and the control module.

17. A battery swapping station, **characterized by** comprising the battery compartment according to any one of claims 1 to 16.
